# DEMANDE DE BREVET EUROPEEN

(11) **EP 4 084 595 A1**
(43) Date de publication de la demande: **02.11.2022**
(21) Numéro de dépôt: 22170117.0
(22) Date de dépôt: 26.04.2022
(51) Int. Cl.: H05K 7/20

(54) **MODULE DE REFROIDISSEMENT COMPRENANT UNE STRUCTURE DE REFROIDISSEMENT POUR LA DISSIPATION THERMIQUE**

(30) Priorité: 29.04.2021 FR 2104497
(71) Demandeur: Valeo eAutomotive France SAS, 95800 Cergy (FR)
(72) Inventeur: VERHOOG, Roel, 95800 C/o Valeo, Cergy (FR)
(74) Mandataire: Valeo Powertrain Systems

(57) **Abrégé**

L'invention concerne une structure alvéolaire de refroidissement (3) configurée pour dissiper la chaleur générée par au moins un composant électronique (40) disposé sur une surface supérieure (21) d'un substrat (2), la structure alvéolaire de refroidissement (3) étant en contact avec une surface intérieu re (22) dudit substrat (2). La structure alvéolaire de refroidissement (3) comprend des cellules dont des bords de cellules augmentent une surface de contact totale entre la structure alvéolaire de refroidissement (3) et un fluide de refroidissement ; et des pores, définis parles cellules et répartis dans le volume de la structure alvéolaire de refroidissement (3), le fluide de refroidissement circulant à travers les pores ou/et à travers des espaces entre les pores.

## Description

### DOMAINE TECHNIQUE ET OBJET DE L'INVENTION

La présente invention se rapporte au domaine des équipements électriques, notamment pour véhicule, en particulier pourvéhicules électriques (« EV », abréviation anglaise) ou hybrides (« HEV », abréviation anglaise).

L'invention porte plus particulièrement sur une structure de refroidissement utilisée dans un module de refroidissement, la structure de refroidissement étant configurée pour dissiper efficacement la chaleur générée par des composants électroniques d'un module électronique.

### ETAT DE LA TECHNIQUE

Un module électronique pour un véhicule électrique ou hybride, par exemple un module électronique de puissance, comprend des composants électroniques qui sont en général disposés sur un substrat du module électronique. Lors du fonctionnement du module électronique, les composants électroniques produisent de la chaleur et doivent être refroidis pour être opérationnels. Un refroidissement efficace des composants électroniques permet notamment d'augmenter la durée de vie des composants électroniques. Le module électronique comprend ainsi un module de refroidissement pour dissiper la chaleur générée par ces composants électroniques.

De façon générale, le substrat comprend une surface supérieure sur laquelle les composants électroniques sont disposés, et une surface inférieure qui est en contact avec le module de refroidissement dans lequel un fluide de refroidissement (e.g. l'eau) circule. La chaleur générée par les composants électroniques est transmise depuis le substrat au module de refroidissement puis est évacuée par le fluide de refroidissement circulé.

De plus, le module de refroidissement peut comprend des broches de refroidissement immergées dans le fluide de refroidissement. Les broches de refroidissement sont en général en métal et facilitent alors l'échange thermique ainsi que la dissipation thermique. Cependant, l'efficacité de la dissipation thermique, réalisée par un tel module de refroidissement, devrait encore être améliorée.

Il existe donc un besoin pour une amélioration du refroidissement des composants électroniques d'un module électronique, au moyen d'une structure de refroidissement présentant une bonne résistance aux chocs thermiques, aux hautes températures, à l'humidité et aux hautes pressions.

### PRESENTATION GENERALE DE L'INVENTION

La présente invention concerne une structure alvéolaire de refroidissement configurée pour dissiper la chaleur générée par au moins un composant électronique disposé sur une surface supérieure d'un substrat, la structure alvéolaire de refroidissement étant en contact avec une surface intérieure dudit substrat. La structure alvéolaire de refroidissement comprend des cellules dont des bords de cellules augmentent une surface de contact totale entre la structure alvéolaire de refroidissement et un fluide de refroidissement ; et des pores, définis parles cellules et répartis dans le volume de la structure alvéolaire de refroidissement, le fluide de refroidissement circulant à travers les pores ou/et à travers des espaces entre les pores.

Avantageusement, la structure alvéolaire de refroidissement est fabriquée par impression 3D.

De façon avantageuse, les cellules sont de type ouvert et/ou de type fermé ; les pores étant de type interconnecté et/ou de type scellé.

De manière préférentielle, la structure alvéolaire de refroidissement est en contact avec une zone de contact de la surface inférieure, ainsi qu'étant immergée dans le fluide de refroidissement.

Préférentiellement, la structure alvéolaire de refroidissement comprend des portions respectivement liées à des régions de contact et/ou à des points de contact répartis dans la zone de contact de la surface inférieure.

Avantageusement, la structure alvéolaire de refroidissement est un monobloc comprenant les portions, ou alternativement, les portions de la structure alvéolaire de refroidissement sont indépendantes les unes des autres.

De façon avantageuse, la structure alvéolaire de refroidissement est en forme de serpentin.

De manière préférentielle, la structure alvéolaire de refroidissement présente une porosité comprise entre 75% et 95% du volume de la structure alvéolaire de refroidissement.

Préférentiellement, la structure alvéolaire de refroidissement est constituée d'un matériau présentant une conductivité thermique supérieure à celle du fluide de refroidissement.

Avantageusement, la structure alvéolaire de refroidissement est liée à la zone de contact de la surface inférieure par frittage, soudage, collage, ou par compression.

De façon avantageuse, la structure alvéolaire de refroidissement est formée ensemble avec le substrat par impression 3D.

L'invention concerne également un module de refroidissement pourun module électronique, notamment pour véhicule automobile électrique ou hybride, configuré pour dissiper la chaleur générée par le module électronique. Le module de refroidissement comprend au moins une structure alvéolaire de refroidissement comme décrit ci-dessus, l'au moins une structure alvéolaire de refroidissement étant en contact avec au moins un substrat du module électronique.

Avantageusement, le module de refroidissement comprend au moins une chambre configurée pour contenir un fluide de refroidissement et l'au moins une structure alvéolaire de refroidissement.

De façon avantageuse, le module de refroidissement comprend le fluide de refroidissement.

L'invention concerne également un module électronique destiné à être intégré dans un ensemble électrique d'un véhicule automobile électrique ou hybride. Le module électronique comprend au moins un substrat comprenant une surface supérieure et une surface inférieure ; au moins un composant électronique disposé sur la surface supérieure de l'au moins un substrat ; un module de refroidissement comme décrit ci-dessus, le module de refroidissement étant en contact avec la surface inférieure de l'au moins un substrat et comprenant au moins une structure alvéolaire de refroidissement qui est en contact avec la surface inférieure de l'au moins un substrat.

Le module électronique est par exemple un module électronique de puissance, dans lequel l'au moins un composant électronique est une puce semi-conductrice de puissance.

L'invention concerne un ensemble électrique pourun véhicule automobile électrique ou hybride, comprenant un module électronique comme décrit ci-dessus.

Le module électronique est, par exemple, un onduleur ou un convertisseur de tension continu-continu.

### PRESENTATION DES FIGURES

L'invention sera mieux comprise à la lecture de la description qui va suivre, donnée à titre d'exemple, et se référant auxfigures suivantes, données à titre d'exemples non limitatifs, dans lesquelles des références identiques sont données à des objets semblables.
La figure 1 illustre une vue en coupe transversale d'un module électronique équipé d'un module de refroidissement comprenant une structure alvéolaire de refroidissement, selon un mode de réalisation de l'invention ;
Les figures 2 et 3 illustrent le module électronique équipé des structures de diverses formes selon l'invention ;
Les figures 4 et 5 illustrent, selon l'invention, la structure alvéolaire de refroidissement liée à des points de contact du substrat du module électronique ;
La figure 6 illustre la structure alvéolaire de refroidissement comprenant des portions indépendantes les unes des autres, selon un mode de réalisation de l'invention ;
La figure 7 illustre la structure alvéolaire de refroidissement, selon un mode de réalisation de l'invention, n'étant pas en contact avec le fond de la chambre du module de refroidissement ;
La figure 8 illustre le module de refroidissement comprenant une seule structure alvéolaire de refroidissement utilisée pour refroidir les composants électroniques disposés sur deux substrats, selon un mode de réalisation de l'invention ; et
La figure 9 illustre le module de refroidissement comprenant deux structures alvéolaires de refroidissement utilisées pour refroidir au moins un composant électronique disposé entre lesdites structures alvéolaires de refroidissement.

Il faut noter que les figures exposent l'invention de manière détaillée pour mettre en œuvre l'invention, lesdites figures pouvant bien entendu servir à mieuxdéfinir l'invention le cas échéant.

### DESCRIPTION DETAILLEE DE L'INVENTION

De manière générale, l'invention concerne ainsi une structure alvéolaire de refroidissement 3 destinée à être disposée dans un module de refroidissement 5 d'un module électronique 10, pourdissiperla chaleur générée par au moins un composant électronique 40 du module électronique 10.

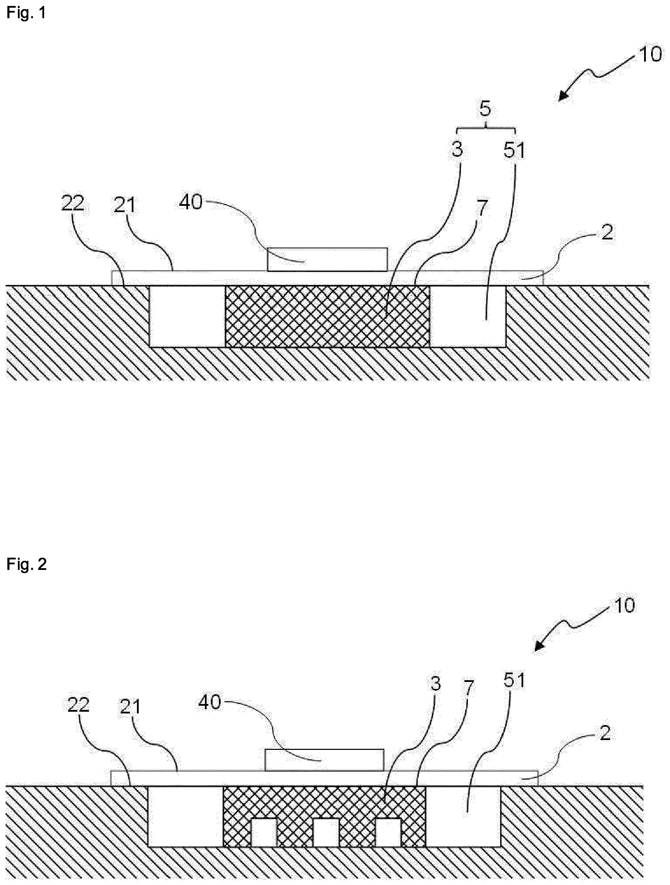

La figure 1 illustre une vue en coupe transversale du module électronique 10 équipé d'un module de refroidissement 5 ayant au moins une structure alvéolaire de refroidissement 3, selon un mode de réalisation de l'invention.

Le module électronique 10 comprend l'au moins un composant électronique 40, au moins un substrat 2 sur lequel l'au moins un composant électronique 40 est disposé, et le module de refroidissement 5. Le module électronique 10 est de préférence un module électronique de puissance. Le module électronique 10 est notamment destiné à être intégré dans un ensemble électrique embarqué dans un véhicule automobile électrique ou hybride. L'ensemble électrique est, parexemple, un onduleurou un convertisseur de tension continu - continu.

L'au moins un composant électronique 40 est en particulier une puce semi-conductrice de puissance. Dans la plupart des cas, le module électronique 10 comprend une pluralité de composants électroniques 40. Néanmoins, pourfaciliter la lecture du texte, dans la plupart des modes de réalisation illustrés ci-après, le module électronique 10 comprend un seul substrat 2 et un seul composant électronique 40.

Le substrat 2 présente, de manière préférentielle, une structure multicouche. Dans un mode de réalisation, le substrat 2 comprend une couche métallique. L'invention n'est ni limitée au nombre de couches ni aux matériaux de couches du substrat 2. De manière préférentielle, le substrat 2 est fabriquée par impression 3D (trois dimensions).

Le substrat 2 présente une surface supérieure 21 et une surface inférieure 22. Les deux surfaces 21 et 22 sont planes. L'au moins composant électronique 40 est disposé sur la surface supérieure 21 alors que la surface inférieure 22 est en contact avec le module de refroidissement 5.

Le module de refroidissement 5 comprend au moins une chambre 51 configurée pour contenir un fluide de refroidissement et l'au moins une structure alvéolaire de refroidissement 3. Dans la plupart des modes de réalisation illustrés ci-après, le module de refroidissement 5 comprend une seule chambre 51 et une seule structure alvéolaire de refroidissement 3.

De manière préférentielle, le fluide de refroidissement circule à travers la chambre 51. Notamment après avoir monté le substrat 2 sur le module de refroidissement 5 de manière étanche, la structure alvéolaire de refroidissement 3 est disposée dans la chambre 51. Le fluide de refroidissement est par exemple de l'eau ou du glycol liquide.

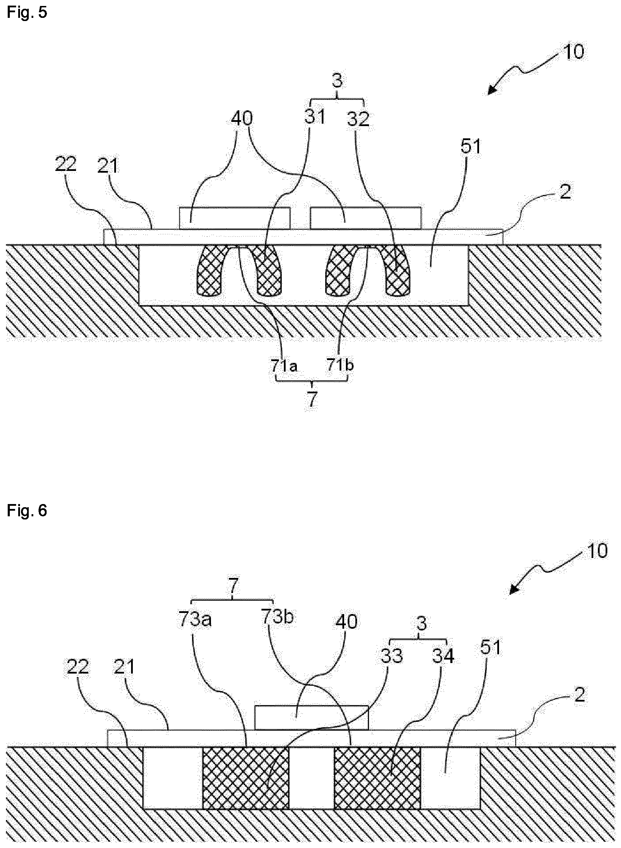

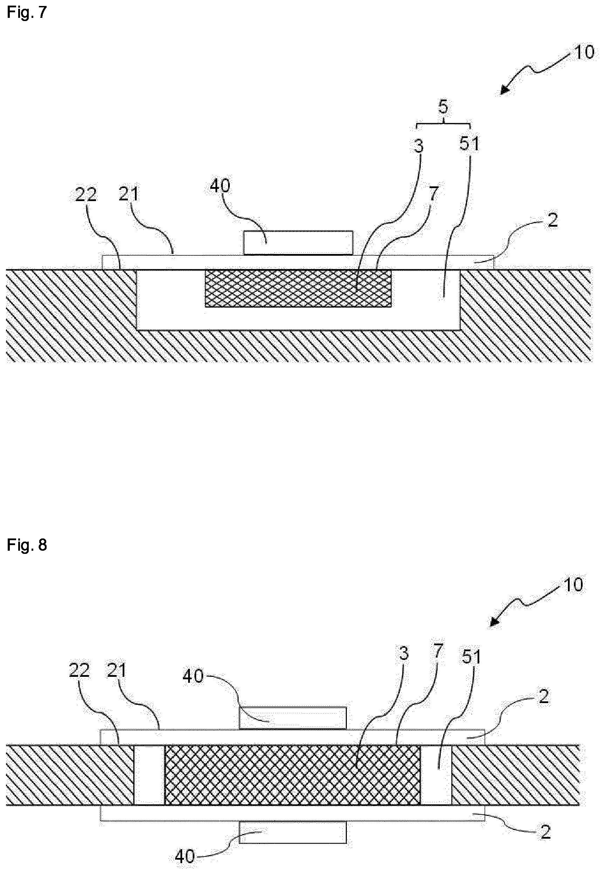

La structure alvéolaire de refroidissement 3 est disposée dans la chambre 51 et est immergée dans le fluide de refroidissement. La structure alvéolaire de refroidissement 3 est par exemple en contact avec le fond de la chambre 51, comme illustré en figure 1. De manière alternative, la structure alvéolaire de refroidissement 3 n'est pas en contact avec le fond de la chambre 51, comme illustré en figures 5 et 7.

La structure alvéolaire de refroidissement 3 est constituée d'un matériau métallique, tel que l'aluminium, l'acier, le cuivre, le magnésium, le nickel et le titane, ou d'un alliage contenant un ou plusieurs des métaux susmentionnés. Le matériau de la structure alvéolaire de refroidissement 3 présente notamment une conductivité thermique meilleure que celle du fluide de refroidissement.

La structure alvéolaire de refroidissement 3 comprend des cellules et des pores qui sont définis par ces cellules. Les cellules ainsi que les pores sont répartis dans le volume de la structure alvéolaire de refroidissement 3. De manière préférentielle, les cellules les pores sont uniformément répartis dans ledit volume. De manière avantageuse, la structure alvéolaire de refroidissement 3 présente une porosité entre 75% et 95% dudit volume. La taille de pores et la porosité de la structure alvéolaire de refroidissement 3 s'adaptent aux exigences souhaitées en matière de fabrication.

Les pores sont destinés à être remplis par le fluide de refroidissement. Les cellules peuvent être de type ouvert ou/et de type fermé. Autrementdit, la structure alvéolaire de refroidissement 3 peut comprendre une combinaison des cellules ouvertes et de celles fermées, ou alternativement, uniquement les cellules ouvertes ou uniquement les cellules fermées. Les pores sont, par conséquent, de type interconnecté ou/et de type scellé. La structure alvéolaire de refroidissement 3 peut comprendre une combinaison des pores interconnectés et de ceux scellés, ou alternativement, uniquement les pores interconnectés (qui sont les pores ouverts définis par les cellules ouvertes) ou uniquement les pores scellés (définis par les cellules fermées).

Dans un mode de réalisation avantageux (non illustré en figures), la structure alvéolaire de refroidissement 3 est un bloc de métal ou d'alliage transpercé de plusieurs trous qui se croisent. Un pore est formé de manière à ce que trois trous dudit bloc se croisent à un même point.

La structure alvéolaire de refroidissement 3 est de préférence en contact avec une zone de contact 7 de la surface inférieure 22 du substrat 2 afin d'augmenter l'efficacité de la dissipation de la chaleur générée par l'au moins un composant électronique 40. La chaleur générée est transmise depuis le substrat 2, à travers la zone de contact 7 à la structure alvéolaire de refroidissement 3, est ensuite évacuée par le fluide de refroidissement circulé.

De manière préférentielle, la structure alvéolaire de refroidissement 3 est fabriqué par impression 3D.

Des bords des cellules de la structure alvéolaire de refroidissement 3 considérablement augmentent la surface d'échange thermique. La surface d'échange thermique est la surface de contact totale entre la structure alvéolaire de refroidissement 3 et le fluide de refroidissement. De plus, le fluide de refroidissement circule à travers des espaces entre les pores scellés et/ou, plus avantageusement, à travers les pores interconnectés, ce qui augmente alors la perméabilité au fluide. L'augmentation de la surface d'échange thermique et de la perméabilité au fluide permet donc d'améliorer la conductivité thermique ainsi que la dissipation de chaleur.

La structure alvéolaire de refroidissement 3 peut être liée à la zone de contact 7 de la surface inférieure 22, parexemple, par frittage, soudage, collage, ou par compression. Dans un mode de réalisation, la structure alvéolaire de refroidissement 3 peut être compressée pour diminuer son volume (notamment pourdiminuer son volume de 30%), afin de s'adapter aux exigences souhaitées en matière de fabrication (e.g. la forme et/ou la taille de la chambre 51, l'emplacement, la forme et/ou la taille de la zone de contact 7).

De manière avantageuse, l'au moins un substrat 2 et l'au moins une structure alvéolaire de refroidissement 3 forment un ensemble. Cet ensemble est, de préférence, fabriqué par impression 3D. Ledit ensemble, notamment celui fabriqué par 3D impression, évite le problème de la jonction (se situant dans ladite zone de contact 7) de la structure alvéolaire de refroidissement 3 et du substrat2, ce qui améliore donc l'efficacité de refroidissement.

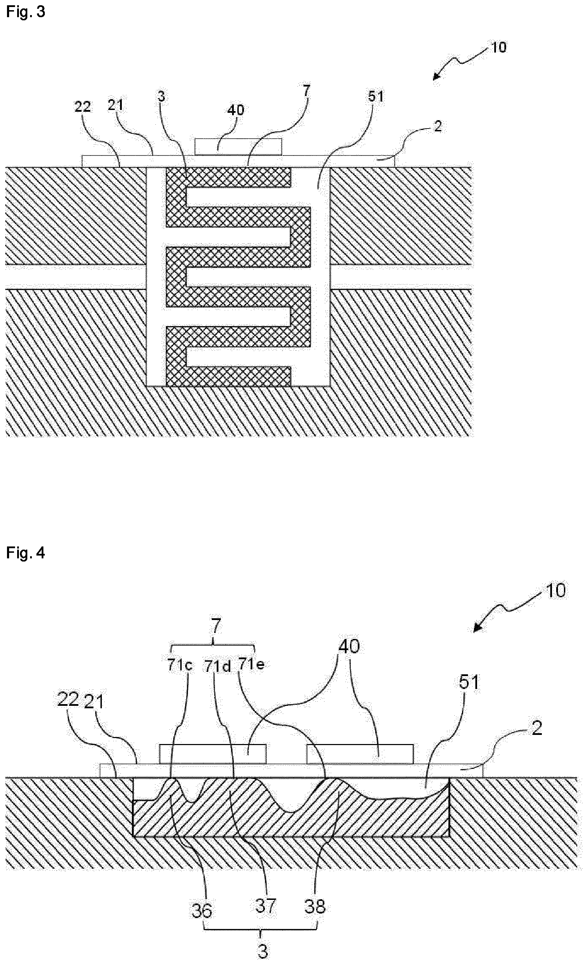

Les figures 2 à 7 illustrent le module électronique 10 équipé des structures alvéolaires de refroidissement 3 de diverses formes et configurations, selon l'invention. Les structures 3 décrite dans les figures 2 à 6, notamment celle en forme de serpentin comme représenté sur la figure 3, présentent respectivement une surface d'échange thermique supérieure à celle de la structure alvéolaire de refroidissement 3 décrite dans la figure 1.

Selon un mode de réalisation, la structure alvéolairede refroidissement3 est monobloc, présentant une forme prédéterminée, comme décrit dans les figures 1 à 4, 7 et 8. Alternativement, la structure alvéolaire de refroidissement 3 comprend plusieurs portions indépendantes les unes des autres, comme décrit dans les figures 5 et 6. La structure alvéolaire de refroidissement 3 de la figure 5 présente des portions indépendantes 31, 32 respectivement en contact avec la surface inférieure 22 du substrat 2, en des points de contact 71a, 71b répartis dans la zone de contact 7. La structure alvéolaire de refroidissement 3 de la figure 6 présente des portions indépendantes 33, 34 respectivement en contact avec la surface inférieure 22 du substrat 2, en des régions de contact 73a, 73b qui constituent la zone de contact 7. L'invention n'est ni limitée au nombre ou aux formes de portions de la structure alvéolaire de refroidissement3, ni au nombre ou auxformes des régions de contact, ni au nombre des points de contact.

Selon un mode de réalisation (non illustré en figures) où la structure alvéolaire de refroidissement 3 occupe toute la chambre 51 du module de refroidissement 5, le fluide de refroidissement ne circule qu'à travers la structure alvéolaire de refroidissement3. Alternativement, comme décrite dans les figures 1 à 9, une portion du fluide de refroidissement circule à travers la structure alvéolaire de refroidissement 3 alors que le reste du fluide de refroidissement circule autour de la structure alvéolaire de refroidissement 3, par exemple à travers des espaces entre la structure alvéolaire de refroidissement 3 et des parois internes de la chambre 51, ou/et des espaces entre la structure alvéolaire de refroidissement 3 et la surface inférieure 22, ou/et les espaces entre des portions différentes de la structure alvéolaire de refroidissement 3.

La figure 5 illustre, comme mentionné ci-dessus, la structure alvéolaire de refroidissement 3 comprenant les portions indépendantes 33, 34 liées aux points de contact 71a, 71b répartis dans la zone de contact 7. De manière préférentielle, la structure alvéolaire de refroidissement 3 est liée (e.g. est soudée) aux points de contact répartis dans la zone de contact 7 de la surface inférieure 22 du substrat sur lequel les composants électroniques 40 sont disposés. Les portions 33 et 34, de préférence en forme de ruban recourbé, présentent respectivement une épaisseur. De manière préférentielle, ces points de contact se situent respectivement à proximité d'une zone présentant une température plus élevée, par exemple au-dessous d'un des composants électroniques40, de sorte à augmenter l'efficacité de la dissipation de chaleur. En outre, dans un mode de réalisation alternatif, comme illustré en figure 4, la structure alvéolaire de refroidissement 3 est un monobloc comprenant des portions 36, 37, 38 qui sont respectivement liées à un ou plusieurs des points de contact 71c, 71d, 71e répartis dans la zone de contact 7, au lieu d'être en contact avec toute la zone de contact 7.

Dans un mode de réalisation avantageux (non illustré en figures), la structure alvéolaire de refroidissement 3 comprend une première portion et une deuxième portion qui est indépendante de la première portion. La première portion est en contact avec la surface inférieure 22 en une région de contact. La deuxième portion comprend des sous-portions (indépendantes ou non) respectivement liée à un ou plusieurs points de contact. Les points de contact et la région de contact constituent la zone de contact 7.

La figure 8 illustre un mode de réalisation de l'invention dans lequel le module électronique 10 comprenant deux substrats 2, et des composants électroniques 40 disposés sur les deux substrats 2. Le module de refroidissement 5, se situant entre les deux substrats 2, comprend une seule structure alvéola ire de refroidissement 3. Le module de refroidissement 5 est utilisé pour refroidir les composants électroniques 40 disposés sur les deux substrats 2 disposé respectivement de part et d'autre du module de refroidissement 5.. La structure alvéolaire de refroidissement 3 est en contact avec les zones de contact 7 desdits substrats 2. De manière avantageuse, les deux substrats 2 et la structure alvéolaire de refroidissement 3 forment un ensemble fabriqué de préférence par impression 3D.

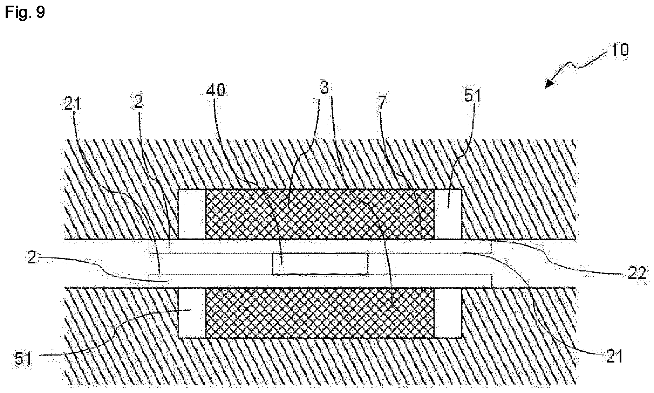

La figure 9 montre un autre mode de réalisation dans lequel le module électronique 10 comprend deux substrats 2, au moins un composant électronique 40 et un module de refroidissement 5 comprenant deux chambres 51 et deux structures alvéolaires de refroidissement 3. L'au moins un composant électronique 40 est disposé entre les deux substrats 2, en étant disposé sur les surfaces supérieures 21 desdits substrats 2. Les structures alvéolaires de refroidissement 3, étant en contact avec les surfaces intérieures 22 desdits substrat 2, sont configurées pour dissiper la chaleurgénérée par l'au moins un composant électronique 40. Par rapport aux modes de réalisation illustrés en figures 1 à 8, l'efficacité de refroidissement du présent mode de réalisation est améliorée.

De manière préférentielle, pour évite le problème de la jonction mentionnée ci-dessus et pour simplifier l'assemblage de composants du module électronique 10, l'au moins un composant électronique 40 est disposé entre, en étant contact avec, deux ensembles comprenant chacun une des deux structures alvéolaires de refroidissement 3 et un des deux substrats 2. Lesdits ensembles sont fabriqués de préférence par impression 3D.

L'invention concerne également d'autres modes de réalisation qui sont des combinaisons de deux ou plusieurs des modes de réalisation mentionnés ci-dessus.

Par rapport aux mécanismes de refroidissement conventionnels (e.g. en présence d'un fluide de refroidissement et avec ou sans broches de refroidissement), la structure alvéolaire de refroidissement 3 selon la présente invention permet d'augmenter la surface d'échange thermique et la perméabilité au fluide de refroidissement, ce qui améliore la conductivité thermique ainsi que la dissipation de chaleur. De plus, la structure alvéolaire de refroidissement 3 est robuste et facilement usinable, en présentant une bonne résistance aux chocs thermiques, aux hautes températures, à l'humidité et aux hautes pressions. Notamment, la structure alvéolaire de refroidissement 3 est également désignée une « mousse », par exemple une mousse métallique.

L'invention n'est pas limitée aux modes de réalisation précédemment décrits mais s'étend à tout mode de réalisation conforme à son esprit.

## Revendications

1. Structure alvéolaire de refroidissement (3) configurée pour dissiper la chaleur générée par au moins un composant électronique (40) disposé sur une surface supérieure (21) d'un substrat (2), la structure alvéolaire de refroidissement (3) étant en contact avec une surface intérieure (22) dudit substrat (2) ; la structure alvéolaire de refroidissement (3) étant **caractérisée en ce qu'**elle comprend :
- des cellules dont des bords de cellules augmentent une surface de contact totale entre la structure alvéolaire de refroidissement (3) et un fluide de refroidissement;
- des pores, définis par les cellules et répartis dans le volume de la structure alvéolaire de refroidissement (3), le fluide de refroidissement circulant à travers les pores ou/et à travers des espaces entre les pores.

2. Structure alvéolaire de refroidissement (3) selon la revendication 1, étant fabriquée par impression 3D.

3. Structure alvéolaire de refroidissement (3) selon la revendication 1 ou 2, dans laquelle
- les cellules sont de type ouvert et/ou de type fermé ;
- les pores sont de type interconnecté et/ou de type scellé.

4. Structure alvéolaire de refroidissement (3) selon l'une quelconque des revendications précédentes, étant en contact avec une zone de contact (7) de la surface inférieure (22), ainsi qu'étant immergée dans le fluide de refroidissement.

5. Structure alvéolaire de refroidissement (3) selon la revendication précédente, comprenant des portions (31 à 34, 36, 37, 38) respectivement liées à des régions de contact (73a, 71b) et/ou à des points de contact (71a à 71e) répartis dans la zone de contact (7) de la surface inférieure (22).

6. Structure alvéolaire de refroidissement (3) selon la revendication précédente, dans laquelle :
- la structure alvéolaire de refroidissement (3) est un monobloc comprenant les portions (36, 37, 38) ; ou
- les portions (31 à 34) sont indépendantes les unes des autres.

7. Structure alvéolaire de refroidissement (3) selon l'une quelconque des revendications précédentes, étant en forme de serpentin.

8. Structure alvéolaire de refroidissement (3) selon l'une quelconque des revendications précédentes, présentant une porosité comprise entre 75% et 95% du volume de la structure alvéolaire de refroidissement (3).

9. Structure alvéolaire de refroidissement (3) selon l'une quelconque des revendications précédentes, étant constituée d'un matériau présentant une conductivité thermique supérieure à celle du fluide de refroidissement.

10. Structure alvéolaire de refroidissement (3) selon l'une quelconque des revendications 4 à 9, étant liée à la zone de contact (7) de la surface inférieure (22) par frittage, soudage, collage, ou par compression.

11. Structure alvéolaire de refroidissement (3) selon l'une quelconque des revendications 1 à 9, étant formée ensemble avec le substrat (2) par impression 3D.

12. Module de refroidissement (5) pour un module électronique (10), notamment pour véhicule automobile électrique ou hybride, configuré pour dissiper la chaleurgénérée par le module électronique (10), le module de refroidissement (5) étant caractérise en ce qu'il comprend au moins une structure alvéolaire de refroidissement (3) selon l'une quelconque des revendications 1 à 11, l'au moins une structure alvéolaire de refroidissement (3) étant en contact avec au moins un substrat (2) du module électronique (10).

13. Module de refroidissement (5) selon la revendication précédente, comprenant au moins une chambre (51) configurée pourcontenir un fluide de refroidissement et l'au moins une structure alvéolaire de refroidissement (3).

14. Module de refroidissement (5) selon la revendication 12 ou 13, comprenant le fluide de refroidissement.

15. Module électronique (10)destinéà être intégré dans un ensemble électrique d'un véhicule automobile électrique ou hybride, le module électronique (10) étant **caractérise en ce qu'**il comprend :
- au moins un substrat (2) comprenant une surface supérieure (21) et une surface inférieure (22) ;
- au moins un composant électronique (40) disposé sur la surface supérieure (21) de l'au moins un substrat (2) ;
- un module de refroidissement (5) selon l'une quelconque des revendications 12 à 14, le module de refroidissement (5) étant en contact avec la surface inférieure (22) de l'au moins un substrat (2) et comprenant au moins une structure alvéolaire de refroidissement (3) qui est en contactavec la surface inférieure (22) de l'au moins un substrat (2).

16. Module électronique (10) selon la revendication précédente, étant un module électronique de puissance, dans lequel l'au moins un composant électronique (40) est une puce semi-conductrice de puissance.

17. Ensemble électrique pour un véhicule automobile électrique ou hybride, comprenant un module électronique (10) selon la revendication 15 ou 16.

18. Ensemble électrique (1) selon la revendication précédente, étant un onduleurou un convertisseur de tension continu-continu.
